# EUROPEAN PATENT SPECIFICATION

(11) **EP 3 903 378 B1**
(45) Date of publication and mention of the grant of the patent: **20.12.2023**
(21) Application number: 19709429.5
(22) Date of filing: 04.03.2019
(51) Int. Cl.: H01Q 1/24, H01Q 21/00, H01Q 21/28

(54) **MILLIMETER-WAVE ASSEMBLY**
MILLIMETERWELLENANORDNUNG
ENSEMBLE À ONDES MILLIMÉTRIQUES

(43) Date of publication of application: 03.11.2021
(73) Proprietor: Huawei Technologies Co., Ltd., Longgang District, Shenzhen, Guangdong 518129 (CN)
(72) Inventor: KHRIPKOV, Alexander, 16440 Kista (SE); LIU, Dong, 80992 Kista (SE); ILVONEN, Janne, 16440 Kista (SE); OU, Jian, 16440 Kista (SE); TIAN, Ruiyuan, 16440 Kista (SE); XU, Changnian, 16440 Kista (SE); HUANG, Wei, 16440 Kista (SE); MILOSAVLJEVIC, Zlatoljub, 16440 Kista (SE); VAN WONTERGHEM, Jari, Kristian, 16440 Kista (SE)
(74) Representative: Huawei European IPR
(86) International application number: PCT/EP2019/055249
(87) International publication number: WO 2020/177846

(56) References cited:
- EP-A1- 3 444 894
- WO-A1-2009/029520
- US-A1- 2019 036 207

## Description

### TECHNICAL FIELD

The disclosure relates to a millimeter-wave (mmWave) assembly comprising a first mmWave module, a second mmWave module, and a connector configured to interconnect the first mmWave module and the second mmWave module.

### BACKGROUND

Electronic devices need to support more and more radio signal technology such as 2G/3G/4G radio. For coming 5G radio technology, the frequency range will be expanded from sub-6 GHz to so called millimeter-wave (mmWave) frequency, e.g. above 20 GHz. For mmWave frequencies, an antenna array will be necessary in order to form a radiation beam with higher gain which overcomes the higher path loss in the propagation media. However, radiation beam patterns with higher gain result in a narrow beam width, wherefore beam steering techniques such as the phased antenna array is used to steer the beam in a specific, desired direction.

Mobile electronic devices, such as mobile phones and tablets, may be oriented in any arbitrary direction. Therefore, such electronic devices need to exhibit an as near full spherical beam coverage as possible. Such coverage is difficult to achieve, i.a. due to the radiation beam being blocked by a conductive housing, a large display, and/or by the hand of the user holding the device.

Conventionally, a mmWave antenna array is arranged next to the display, such that the display does not interfere with the beam coverage. However, the movement towards very large displays, covering as much as possible of the electronic device, makes the space available for the antenna array very limited, forcing either the size of the antenna array to be significantly reduced, and its performance impaired, or a large part of the display to be inactive.

The limited antenna space makes implementing a mmWave antenna array, while getting sufficient beam coverage, difficult. There is not enough space on the display side for a conventional mmWave antenna array in the same module together with the radiofrequency (RF) active circuit circuitry. One solution to this problem is to implement a distributed antenna array, where the mmWave antenna array is arranged in a mechanically separate part other than the RF active circuit circuitry. This allows placing the mmWave antenna within the display clearance while allowing the RF active circuit to be located further away, where there is space.

Patent application publications WO2009029520A1, US20190036207A1 and EP3444894A1 relate to the technological background of the present invention. In particular, WO2009029520A1 discloses an electronic device comprising a radio 102, an array 421, and a flexible interconnect 411. The flexible interconnect 411 is used to connect the RF front end 1005 to the radio 102. The RF front end 1005 can be connected to the antenna arrays 421 using connectors in addition to the flexible interconnects 411 that are used to connect the RF front end 1005 to the radio 102.

### SUMMARY

It is an object to provide an improved mmWave assembly. The foregoing and other objects are achieved by the features of the independent claim.

Further implementation forms are apparent from the dependent claims, the description, and the figures.

Such a solution allows an mmWave assembly which has a small footprint while still having sufficient radiofrequency performance. Furthermore, the mmWave assembly facilitates assembly and repair, by dividing the assembly into at least two, repeatedly attachable and detachable, parts. Additionally, the detachability allows the mmWave assembly to use any available space within, e.g., an electronic device.

In a further possible implementation form of the first aspect, the mmWave antenna array comprises at least one mmWave antenna, and the connector is configured to transmit the signal between the mmWave RFIC and the mmWave antenna(s), facilitating sufficient signal strength and directional coverage.

The connector comprises a third connector element, the first connector element and the second connector element engaging through the third connector element, allowing interconnecting sections to be arranged on a separate element.

The third connector element comprises a first section and a second section, the first section engaging the first connector element and the second section engaging the second connector element, facilitating a third connector element having as small footprint as possible.

In a further possible implementation form of the first aspect, the connector transmits the signal by means of engagement the first section of the third connector element and the first connector element or the second section of the third connector element and the second connector element, facilitating signal transmission between the first substrate and a plurality of antenna arrays.

In a further possible implementation form of the first aspect, the engagement comprises a galvanic connection facilitating a direct current flow.

In a further possible implementation form of the first aspect, the engagement comprises a non-galvanic connection provided by means of inductive or capacitive near field coupling between at least two of the first connector element, the second connector element, and the third connector element, facilitating isolation of selected components by preventing direct current flow between these components.

In a further possible implementation form of the first aspect, at least one of the first connector element, the second connector element, and the third connector element comprises a coplanar structure, allowing a mmWave assembly which has a small footprint and the shape of which can be adapted to space available, as well as allowing interconnection of one or more mmWave antenna arrays to the first substrate.

At least one of the first connector element, the second connector element, and the third connector element comprises a spring structure, allowing the mmWave assembly to be at least partially flexible which facilitates assembly and reduces the tolerances needed.

In a further possible implementation form of the first aspect, the first mmWave module comprises a further mmWave antenna array, the further mmWave antenna array comprising at least one mmWave antenna, facilitating increased signal strength and directional coverage.

In a further possible implementation form of the first aspect, at least one of the first substrate and the second substrate is a flexible or rigid printed circuit board, reducing the need for additional antenna components.

According to a second aspect, there is provided an electronic device comprising a device chassis, a mmWave assembly according to the above, and a housing enclosing the device chassis and the mmWave assembly, the first mmWave module of the mmWave assembly being connected to the device chassis. This solution allows an mmWave assembly which has a small footprint while still having sufficient radiofrequency performance. Furthermore, the mmWave assembly facilitates assembly and repair, by dividing the assembly into at least two, repeatedly attachable and detachable, parts. Additionally, the detachability allows the mmWave assembly to use any available space within the electronic device.

In a possible implementation form of the second aspect, the mmWave assembly comprises at least one mmWave antenna array, each mmWave antenna array extending adjacent a face of the housing, and facilitating sufficient signal strength and directional coverage.

This and other aspects will be apparent from the embodiments described below.

### BRIEF DESCRIPTION OF THE DRAWINGS

In the following detailed portion of the present disclosure, the aspects, embodiments and implementations will be explained in more detail with reference to the example embodiments shown in the drawings, in which:
Fig. 1 shows a schematic cross-sectional side view of a millimeter-wave assembly mounted in an electronic device in accordance with one embodiment of the present invention;
Fig. 2 shows a schematic cross-sectional side view of a millimeter-wave assembly mounted in an electronic device in accordance with a further embodiment of the present invention;
Fig. 3 shows a schematic cross-sectional side view of a millimeter-wave assembly mounted in an electronic device in accordance with yet another embodiment of the present invention;
Fig. 4 shows a schematic cross-sectional side view of a millimeter-wave assembly mounted in an electronic device in accordance with yet another embodiment of the present invention;
Fig. 5 shows a schematic cross-sectional side view of a millimeter-wave assembly mounted in an electronic device in accordance with yet another embodiment of the present invention;
Fig. 6 shows a schematic cross-sectional side view of a millimeter-wave assembly mounted in an electronic device in accordance with yet another embodiment of the present invention;
Fig. 7a shows a perspective view of a millimeter-wave assembly and an electronic device in accordance with one embodiment of the present invention;
Fig. 7b shows a perspective view of the embodiment of Fig. 7a, wherein the millimeter-wave assembly is mounted into the electronic device;
Fig. 8a shows a schematic side view of a millimeter-wave assembly in accordance with one embodiment of the present invention;
Fig. 8b shows a schematic side view of a millimeter-wave assembly in accordance with a further embodiment of the present invention;
Fig. 9 shows a schematic side view of a section of a millimeter-wave assembly in accordance with yet another embodiment of the present invention.

### DETAILED DESCRIPTION

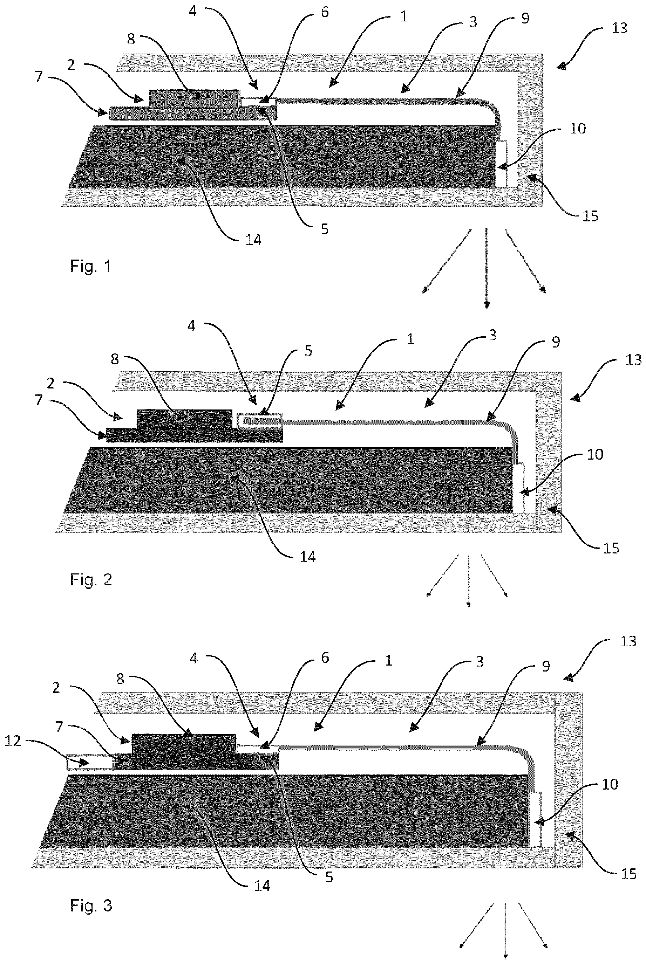

Figs. 1 to 7b show an electronic device 13 comprising a device chassis 14, a millimeter-Wave (mmWave) assembly 1, described in more detail further below, and a housing 15 enclosing the device chassis 14 and the mmWave assembly 1. The mmWave assembly 1 comprises at least a first mmWave module 2, a second mmWave module 3, and a connector 4 configured to releasably interconnect the first mmWave module 2 and the second mmWave module 3.

The first mmWave module 2 of the mmWave assembly 1 may be connected to the device chassis 14, or an internal component of the electronic device 13 such as a flexible or rigid printed circuit board (PCB). The flexible PCB may be a liquid crystal polymer (LCP) PCB.

In one embodiment, the mmWave assembly 1 comprises at least one mmWave antenna array 10, 12, each mmWave antenna array 10, 12 extending adjacent a face of the housing 15.

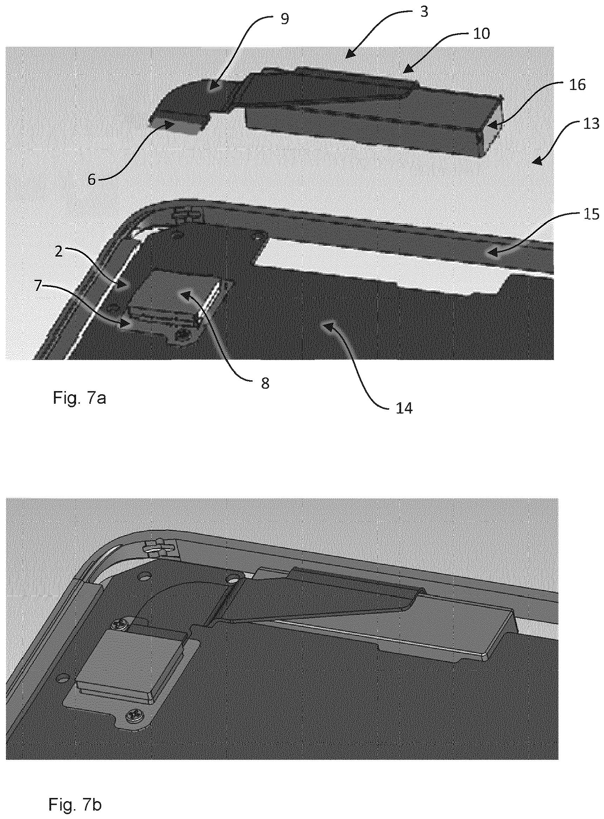

The present disclosure further relates to a method of assembling the electronic device 13 which, comprises a plurality of sequential, or nonsequential, steps. As shown in Fig. 7a, the first mmWave module 2 of the mmWave assembly 1 is connected to the device chassis 14. The second mmWave module 3 of the mmWave assembly 1 is connected to the device chassis 14, the housing 15, and/or an electromechanical module 16 arranged between the device chassis 14 and the housing 15, as also shown in Fig. 7a. The first mmWave module 2 engages with the second mmWave module 3, as shown in Fig. 7b, by means of a connector 4. In one embodiment, the second mmWave module 3 of the mmWave assembly 1 is connected to the electromechanical module 16. The electromechanical module 16 may be, e.g., a camera module.

As mentioned above, the millimeter-wave (mmWave) assembly 1 comprises a first mmWave module 2, a second mmWave module 3, and a connector 4 configured to releasably interconnect the first mmWave module 2 and the second mmWave module 3.

The connector 4 comprises at least a first connector element 5, associated with the first mmWave module 2. By "associated" is meant being connected by means of, e.g., screws, adhesive, soldering or similar.

The first mmWave module 2 comprises at least a first substrate 7 and a mmWave radiofrequency integrated circuit (RFIC) 8. The second mmWave module 3 comprises at least a second substrate 9 and a mmWave antenna array 10. At least one of the first substrate 7 and the second substrate 9 may be a flexible or rigid printed circuit board.

In one embodiment, the first mmWave module 2 comprises a further mmWave antenna array 12. mmWave antenna array 12 may be arranged such that it generates radiation in the same direction, or in different directions, than the radiation generated by mmWave antenna array 10.

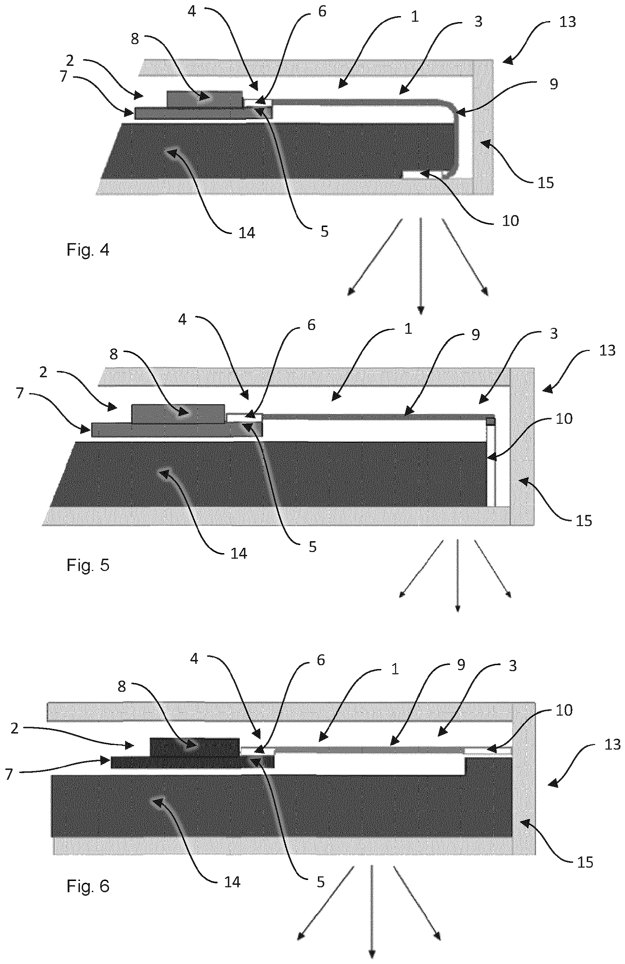

One or both of the mmWave antenna arrays 10, 12 may extend at an angle ≥ 0° to a main plane of the first substrate. mmWave antenna array 10 may extend essentially perpendicular, i.e. at 90°, to the main plane of the first substrate 7, as shown in Figs. 1 to 3 and 5. mmWave antenna array 10 may extend essentially parallel to the main plane of the first substrate 7, as shown in Figs. 4, showing a 180° angle, and 6, showing a 0° angle. mmWave antenna array 12 may extend essentially parallel to the main plane of the first substrate 7, and as shown in Fig.3, extend in the main plane of the first substrate 7.

The above-mentioned angle is achieved by means of either a bend in the second substrate 9, as shown in Figs. 1 to 4, or by means of the second substrate 9 and the mmWave antenna array 10 being split into separate elements, as shown in Fig. 5, the separate elements being fixedly interconnected by means of, e.g., soldering or being releasably interconnected by means of the galvanic or non-galvanic connections described further below. The angle may also be achieved by means of a plurality of bends, e.g. two 45° bends (not shown).

Each antenna array 10, 12 may be arranged such that one end of the array is located closer to the first substrate 7 than the other end of the array. Furthermore, each antenna array 10, 12 may be arranged such that one end of the array is located closer to the second substrate 9 than the other end of the array. The distance between the respective ends of the array, and the first and/or second substrate, may be seen in any direction, including directions perpendicular to, and parallel with, a main plane of the first substrate 7 and/or the second substrate 9. One or both mmWave antenna arrays 10, 12 may be offset in at least one direction in relation to the main plane of the first substrate 7 and/or the second substrate 9. As shown in Figs. 4 and 6, the antenna arrays 10, 12 may extend parallel to the main plane of the first substrate 7, but at a distance from the first substrate 7, such that the antenna array extends between the device chassis 14 and a rear or front section of the housing 15. As shown in Figs. 1 to 3 and 5, the antenna arrays 10, 12 may extend perpendicular to the main plane of the first substrate 7, but at a distance from the first substrate 7 such that the antenna array extends between the device chassis 14 and a side section of the housing 15. Furthermore, the antenna arrays 10, 12 may extend in a main plane of the second substrate 9, as shown in Fig. 6.

The connector 4 is configured to transmit at least one signal between the mmWave RFIC 8 and the mmWave antenna array 10 when the first mmWave module 2 and the second mmWave module 3 are interconnected. In one embodiment, the mmWave antenna array 10 comprises a plurality of mmWave antennas, and the connector 4 is configured to transmit a signal between the mmWave RFIC 8 and each one of the plurality of mmWave antennas. mmWave antenna array 12 may also comprise a plurality of mmWave antennas.

As shown in Figs. 1 to 6, connector 4 comprises at least a first connector element 5, associated with the first mmWave module 2.

In one embodiment, shown in Fig. 2, the first connector element 5 engages directly with the second substrate 9, e.g. by means of a female receptacle soldered to the first substrate 7 and a male counterpart formed within the second substrate 9, such as etched metal pads comprising signal and ground connections.

The connector 4 further comprises a second connector element 6, associated with the second mmWave module 3, as shown in Figs. 1 and 3 to 6. The first mmWave module 2 engages with the second mmWave module 3 by means of the first connector element 5 engaging with the second connector element 6. The first connector element 5 may be soldered to the first substrate 7 and the second connector element 6 may be soldered to the second substrate 9. As shown in Figs.1 and 3 to 6, the first connector element 5 may engage directly with the second connector element 6.

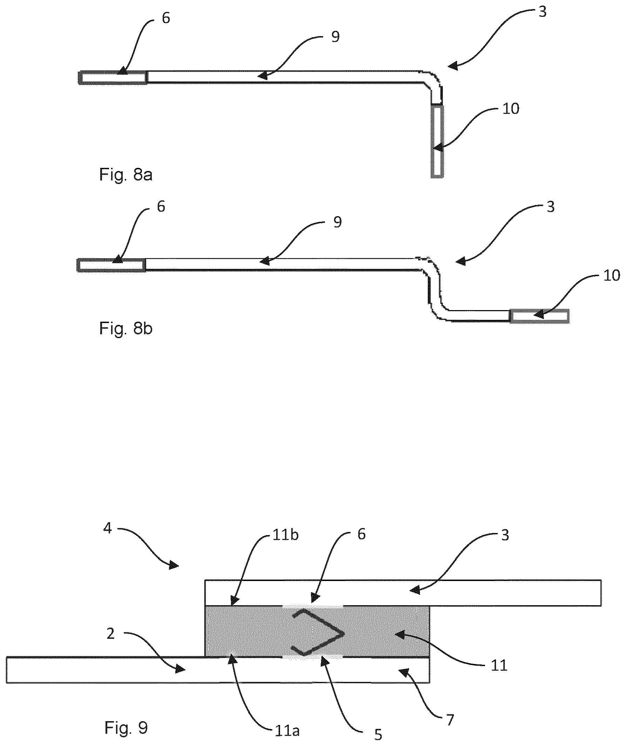

In one embodiment according to the claimed invention, shown in Fig. 9, the first mmWave module 2 engages with the second mmWave module 3 by means of a third connector element 11, the first connector element 5 and the second connector element 6 engaging through the third connector element 11. In one embodiment, the third connector element 11 is sandwiched between the first connector element 5 and the second connector element 6. The third connector element 11 comprises a first section 11a and a second section 11b, the first section 11a engaging the first connector element 5 and the second section 11b engaging the second connector element 6.

The connector 4 may transmit the signal(s) by means of engagement between the first connector element 5 and the second substrate 9, as shown in Fig. 2. The connector 4 may transmit the signal(s) by means of engagement between the first connector element 5 and the second connector element 6, as shown in Figs 1 and 3 to 6. Furthermore, the connector 4 may transmit the signal(s) by means of engagement between the first section 11a of the third connector element 11 and the first connector element 5, and/or the second section 11b of the third connector element 11 and the second connector element 6, as shown in Fig. 9. The first section 11a and/or the second section 11b may comprise galvanic connecting members.

In one embodiment, the direct engagement comprises a galvanic connection provided by means of e.g. a zero insertion force (ZIF) connector, a coaxial connector, and/or a combination of connections. The ZIF connector may comprise of one or several coplanar structures. The coplanar structure(s) may be implemented by other means than ZIF such as mating springs integrated within a board-to-board connector.

In a further embodiment, the engagement comprises a non-galvanic connection provided by means of inductive or capacitive near field coupling between at least two of the first connector element 5, the second connector element 6, and the third connector element 11. The two connected elements should be arranged at a maximum distance of 1/10 of the operating wavelength of the antenna array 10, 12.

In one embodiment according to the claimed invention, at least one of the first connector element 5, the second connector element 6, and the third connector element 11 comprise a spring structure.

The various aspects and implementations have been described in conjunction with various embodiments herein. However, other variations to the disclosed embodiments can be understood and effected by those skilled in the art in practicing the claimed subject-matter, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

The reference signs used in the claims shall not be construed as limiting the scope.

## Claims

1. A millimeter-wave, mmWave, assembly (1) comprising a first mmWave module (2), a second mmWave module (3), and a connector (4) configured to releasably interconnect said first mmWave module (2) and said second mmWave module (3),
said first mmWave module (2) comprising a first substrate (7) and a mmWave radiofrequency integrated circuit, RFIC, (8), said second mmWave module (3) comprising a second substrate (9) and a mmWave antenna array (10),
said connector (4) being configured to transmit at least one signal between said mmWave RFIC (8) and said mmWave antenna array (10) when said first mmWave module (2) and said second mmWave module (3) are interconnected;
**characterised in that**
said connector (4) comprising a first connector element (5) connected to said first mmWave module (2), a second connector element (6) connected to said second mmWave module (3) and a third connector element (11), wherein at least one of said first connector element (5), said second connector element (6) and said third connector element (11) comprises a spring structure;
said first connector element (5) configured to releasably engage a first section (11a) of said third connector element (11) and said
second connector element (6) configured to releasably engage a second section (11b) of said third connector element (11).

2. The mmWave assembly (1) according to claim 1, wherein said mmWave antenna array (10) comprises at least one mmWave antenna, and said connector (4) is configured to transmit said signal between said mmWave RFIC (8) and said mmWave antenna(s).

3. The mmWave assembly (1) according to claim 1 or 2, wherein said connector (4) is configured to transmit said signal by means of engagement between at least one of:
- said first section (11a) of said third connector element (11) and said first connector element (5), or
- said second section (11b) of said third connector element (11) and said second connector element (6).

4. The mmWave assembly (1) according to claim 3, wherein said engagement comprises a galvanic connection.

5. The mmWave assembly (1) according to claim 3, wherein said engagement comprises a non-galvanic connection provided by means of inductive or capacitive near field coupling between at least two of said first connector element (5), said second connector element (6), and said third connector element (11).

6. The mmWave assembly (1) according to any one of the previous claims, wherein at least one of said first connector element (5), said second connector element (6), and said third connector element (11) comprises a coplanar structure.

7. The mmWave assembly (1) according to any one of the previous claims, wherein said first mmWave module (2) comprises a further mmWave antenna array (12), said further mmWave antenna array (12) comprising at least one mmWave antenna.

8. An electronic device (13) comprising a device chassis (14), a millimeter-wave, mmWave, assembly (1) according to any one of claims 1 to 7, and a housing (15) enclosing said device chassis (14) and said mmWave assembly (1), the first mmWave module (2) of said mmWave assembly (1) being connected to said device chassis (14).

9. The electronic device (13) according to claim 8, wherein said mmWave assembly (1) comprises at least one mmWave antenna array (10, 12), each mmWave antenna array (10, 12) extending adjacent a face of said housing (15).

## Patentansprüche

1. Millimeterwellenbaugruppe, mmWave-Baugruppe, (1), umfassend ein erstes mmWave-Modul (2), ein zweites mmWave-Modul (3) und einen Verbinder (4), der dazu konfiguriert ist, das erste mmWave-Modul (2) und das zweite mmWave-Modul (3) lösbar miteinander zu verbinden,
wobei das erste mmWave-Modul (2) ein erstes Substrat (7) und eine integrierte mmWave-Hochfrequenzschaltung, RFIC, (8) umfasst, wobei das zweite mmWave-Modul (3) ein zweites Substrat (9) und ein mmWave-Antennenarray (10) umfasst,
wobei der Verbinder (4) dazu konfiguriert ist, mindestens ein Signal zwischen der mmWave-RFIC (8) und dem mmWave-Antennenarray (10) zu übertragen, wenn das erste mmWave-Modul (2) und das zweite mmWave-Modul (3) miteinander verbunden sind;
**dadurch gekennzeichnet, dass**
der Verbinder (4) ein erstes Verbinderelement (5), das mit dem ersten mmWave-Modul (2) verbunden ist, ein zweites Verbinderelement (6), das mit dem zweiten mmWave-Modul (3) verbunden ist, und ein drittes Verbinderelement (11) umfasst, wobei mindestens eines von dem ersten Verbinderelement (5), dem zweiten Verbinderelement (6) und dem dritten Verbinderelement (11) eine Federstruktur umfasst,
das erste Verbinderelement (5) dazu konfiguriert ist, lösbar mit einem ersten Abschnitt (11a) des dritten Verbinderelements (11) in Eingriff zu kommen, und das zweite Verbinderelement (6) dazu konfiguriert ist, lösbar mit einem zweiten Abschnitt (11b) des dritten Verbinderelements (11) in Eingriff zu kommen.

2. mmWave-Baugruppe (1) nach Anspruch 1, wobei das mmWave-Antennenarray (10) mindestens eine mmWave-Antenne umfasst und der Verbinder (4) dazu konfiguriert ist, das Signal zwischen der mmWave-RFIC (8) und der(den) mmWave-Antenne(n) zu übertragen.

3. mmWave-Baugruppe (1) nach Anspruch 1 oder 2, wobei der Verbinder (4) dazu konfiguriert ist, das Signal durch Eingriff zwischen mindestens einem der Folgenden zu übertragen:
- dem ersten Abschnitt (11a) des dritten Verbinderelements (11) und des ersten Verbinderelements (5), oder
- dem zweiten Abschnitt (11b) des dritten Verbinderelements (11) und des zweiten Verbinderelements (6).

4. mmWave-Baugruppe (1) nach Anspruch 3, wobei der Eingriff eine galvanische Verbindung umfasst.

5. mmWave-Baugruppe (1) nach Anspruch 3, wobei der Eingriff eine nicht-galvanische Verbindung umfasst, die durch induktive oder kapazitive Nahfeldkopplung zwischen mindestens zwei von dem ersten Verbinderelement (5), dem zweiten Verbinderelement (6) und dem dritten Verbinderelement (11) bereitgestellt ist.

6. mmWave-Baugruppe (1) nach einem der vorhergehenden Ansprüche, wobei mindestens eines von dem ersten Verbinderelement (5), dem zweiten Verbinderelement (6) und dem dritten Verbinderelement (11) eine koplanare Struktur umfasst.

7. mmWave-Baugruppe (1) nach einem der vorhergehenden Ansprüche, wobei das erste mmWave-Modul (2) ein weiteres mmWave-Antennenarray (12) umfasst, wobei das weitere mmWave-Antennenarray (12) mindestens eine mmWave-Antenne umfasst.

8. Elektronische Vorrichtung (13), umfassend ein Vorrichtungschassis (14), eine Millimeterwellenbaugruppe, mmWave-Baugruppe, (1) nach einem der Ansprüche 1 bis 7 und ein Gehäuse (15), welches das Vorrichtungschassis (14) und die mmWave-Baugruppe (1) umschließt, wobei das erste mmWave-Modul (2) der mmWave-Baugruppe (1) mit dem Vorrichtungschassis (14) verbunden ist.

9. Elektronische Vorrichtung (13) nach Anspruch 8, wobei die mmWave-Baugruppe (1) mindestens ein mmWave-Antennenarray (10, 12) umfasst, wobei sich jedes mmWave-Antennenarray (10, 12) benachbart an einer Fläche des Gehäuses (15) erstreckt.

## Revendications

1. Ensemble (1) à ondes millimétriques, mmWave, comprenant un premier module mmWave (2), un second module mmWave (3) et un connecteur (4) configuré pour interconnecter de manière amovible ledit premier module mmWave (2) et ledit second module mmWave (3),
ledit premier module mmWave (2) comprenant un premier substrat (7) et un circuit intégré radiofréquence, RFIC, mmWave, (8), ledit second module mmWave (3) comprenant un second substrat (9) et un réseau d'antennes mmWave (10), ledit connecteur (4) étant configuré pour transmettre au moins un signal entre ledit RFIC mmWave (8) et ledit réseau d'antennes mmWave (10) lorsque ledit premier module mmWave (2) et ledit second module mmWave (3) sont interconnectés ;
**caractérisé en ce que**
ledit connecteur (4) comprenant un premier élément de connecteur (5) connecté audit premier module mmWave (2), un deuxième élément de connecteur (6) connecté audit second module mmWave (3) et un troisième élément de connecteur (11), dans lequel au moins l'un dudit premier élément de connecteur (5), dudit deuxième élément de connecteur (6) et dudit troisième élément de connecteur (11) comprend une structure de ressort ;
ledit premier élément de connecteur (5) étant configuré pour venir en prise de manière amovible avec une première section (11a) dudit troisième élément de connecteur (11) et ledit deuxième élément de connecteur (6) étant configuré pour venir en prise de manière amovible avec une seconde section (11b) dudit troisième élément de connecteur (11).

2. Ensemble mmWave (1) selon la revendication 1, dans lequel ledit réseau d'antennes mmWave (10) comprend au moins une antenne mmWave, et ledit connecteur (4) est configuré pour transmettre ledit signal entre ledit RFIC mmWave (8) et ladite ou lesdites antennes mmWave.

3. Ensemble mmWave (1) selon la revendication 1 ou 2, dans lequel ledit connecteur (4) est configuré pour transmettre ledit signal au moyen d'une mise en prise entre au moins l'une parmi :
- ladite première section (11a) dudit troisième élément connecteur (11) et dudit premier élément connecteur (5), ou
- ladite seconde section (11b) dudit troisième élément connecteur (11) et dudit deuxième élément connecteur (6).

4. Ensemble mmWave (1) selon la revendication 3, dans lequel ladite mise en prise comprend une connexion galvanique.

5. Ensemble mmWave (1) selon la revendication 3, dans lequel ladite mise en prise comprend une connexion non galvanique fournie au moyen d'un couplage en champ proche inductif ou capacitif entre au moins deux dudit premier élément de connecteur (5), dudit deuxième élément de connecteur (6) et dudit troisième élément connecteur (11).

6. Ensemble mmWave (1) selon l'une quelconque des revendications précédentes, dans lequel au moins l'un dudit premier élément de connecteur (5), dudit deuxième élément de connecteur (6) et dudit troisième élément de connecteur (11) comprend une structure coplanaire.

7. Ensemble mmWave (1) selon l'une quelconque des revendications précédentes, dans lequel ledit premier module mmWave (2) comprend un autre réseau d'antennes mmWave (12), ledit autre réseau d'antennes mmWave (12) comprenant au moins une antenne mmWave.

8. Dispositif électronique (13) comprenant un châssis de dispositif (14), un ensemble à ondes millimétriques, mmWave, (1) selon l'une quelconque des revendications 1 à 7, et un boîtier (15) renfermant ledit châssis de dispositif (14) et ledit ensemble mmWave (1), le premier module mmWave (2) dudit ensemble mmWave (1) étant connecté audit châssis de dispositif (14).

9. Dispositif électronique (13) selon la revendication 8, dans lequel ledit ensemble mmWave(1) comprend au moins un réseau d'antennes mmWave (10, 12), chaque réseau d'antennes mmWave (10, 12) s'étendant adjacent à une face dudit boîtier (15).
